Europäisches Patentamt

European Patent Office

Office européen des brevets

(19)

(11) **EP 1 610 366 A1**

(12) **EUROPEAN PATENT APPLICATION**
published in accordance with Art. 158(3) EPC

(43) Date of publication:
**28.12.2005 Bulletin 2005/52**

(51) Int Cl.7: **H01L 21/304**, B08B 3/04,
B08B 7/00, G03F 1/08

(21) Application number: **04724771.3**

(22) Date of filing: **31.03.2004**

(86) International application number:
**PCT/JP2004/004634**

(87) International publication number:
**WO 2004/088735 (14.10.2004 Gazette 2004/42)**

(84) Designated Contracting States:
**AT BE BG CH CY CZ DE DK EE ES FI FR GB GR
HU IE IT LI LU MC NL PL PT RO SE SI SK TR**
Designated Extension States:
**AL LT LV MK**

(30) Priority: **31.03.2003 JP 2003097092**

(71) Applicant: **HOYA CORPORATION
161-8525 Tokyo (JP)**

(72) Inventor: **TAKUSHIMA, Katsuhiro
Shinjuku-ku, Tokyo 1618525 (JP)**

(74) Representative: **Betten & Resch
Patentanwälte,
Theatinerstrasse 8
80333 München (DE)**

(54) **CLEANING METHOD, METHOD FOR REMOVING FOREIGN PARTICLE, CLEANING APPARATUS AND CLEANING LIQUID**

(57) The present invention provides a mechanism capable of removing a minute particle adhered to a fine pattern or the like without giving damages to the pattern or the like. After being installed on a device which can perform rotating operation, the high viscosity liquid is dropped on an upper surface of an object such as a photomask to be cleaned by a liquid supply part, and then the photomask is rotated to move the high viscosity liquid. During the movement of the high viscosity liquid, a particle adhered to the object such as the photomask is contained in the high viscosity liquid, and is removed. Further, the particle thus contained in the liquid is prevented from re-adhering to the object such as the photomask by controlling a zeta potential of the high viscosity liquid, and is removed from the object such as the photomask.

FIG. 1

## Description

Technical Field

The present invention relates to a cleaning method, a particle removing method, a cleaning apparatus and cleaning liquid for removing particles such as dirt adhered to an object such as a photomask or a semiconductor wafer.

Background Art

For example, if a particle is adhered to a photomask that is used as a mask for fine pattern transfer, which is required when manufacturing semiconductor device such as an LSI or a liquid crystal panel, the particle is transferred as a defect. Therefore, when manufacturing the photomask, a cleaning process for removing the particle is provided as one of important processes.

The cleaning process executed for manufacturing the photomask includes a step of cleaning a substrate (glass substrate) having no patterned portion, a step of cleaning a substrate formed with a metal thin film thereon for forming a patterned portion on the glass substrate (blanks), and a step of cleaning a substrate (photomask) formed with a pattern thereon.

The cleaning method used in these cleaning steps includes a physical cleaning and a chemical cleaning. The physical cleaning includes a scrub cleaning performed by scrubbing a surface of the substrate using a PVA sponge, a high-pressure water cleaning performed by pressure-applied rinse water, and an ultrasonic wave cleaning using frequencies ranging from KHz to MHz.

The chemical cleaning includes SPM cleaning (cleaning liquid; $H_2SO_4/H_2O_2$, cleaning temperature; 40-100°C), APM cleaning (cleaning liquid; $NH_4OH/H_2O_2/H_2O$, cleaning temperature; RT-40°C) (see Non-Patent Document 1).

There are also proposed a method using ozone water including ozone dissolved therein (see Non-Patent Document 2) and a method using electrolytic water. In some cases, ultrasonic wave, i.e. physical cleaning is used together, to improve a cleaning effect of the APM cleaning i.e. chemical cleaning. Effective removal of the particle is difficult unless specific cleaning conditions are adequately selected according to the type, size, and adhesion mechanism of the particle to be removed.

[Non-Patent Document 1] M. Takahashi, H. Handa, and H. Shirai, "The knack for reticle cleaning", Proceeding of Photomask and Next-generation Lithography Mask Technology VII, SPIE Vol. 4066, pp. 409-415, 2000

[Non-Patent Document 2] Y.S. Son, S.H. Jeong, J.B. Kim and H.S. Kim, "ArF-Half-Tone PSM Cleaning Process Optimization for Next-generation Lithography", Proceeding of Photomask and Next-Generation Lithography Mask Technology VII, SPIE Vol. 4066, pp.416-423, 2000.

Disclosure of the Invention

In association with rapid microminiaturization of a pattern in recent years, the photomask is also required to be free of particles of 0.15 μm or larger in size on an area where light is transmitted (hereinafter referred to as light-transmitting portion). In addition, in association with shortening of the wavelength of exposure light, requirements for particles will be increasingly strict in the future. However, it is revealed that fulfillment of such strict requirements with the conventional physical cleaning or the chemical cleaning described above is very difficult. In other words, although countermeasures such as increasing the number of times of cleaning have been taken in order to fulfill the above-described requirements, sufficient effect has not been achieved.

In addition, in association with the microminiaturization of the patterned portion formed on the photomask, flow of cleaning liquid can hardly be established at the light-transmitting portion between the patterns. From this reason as well, cleaning effect cannot be achieved. Furthermore, a specific mask, that is, a phase-shift mask, is increasingly used in order to improve a resolution of the photomask. In the case of a half-tone mask, which is one of the phase-shift mask, a half-tone film (a metal film based on MoSi material), which forms the patterned portion, has low resistivity against liquid having alkaline characteristics. Therefore, problem involved therein is that the APM cleaning which is used for cleaning the photomask cannot be continued for a long time.

Moreover, in the mask which achieves the phase-shift effect by trenching the glass substrate, the lower portion of the mask pattern has an undercut shape. When the particle exists in this undercut portion, it may be hidden under the lower portion of the mask pattern, and hence may not be detected as the foreign substance by a process of detecting the particle on the surface of the photomask. However, there is a problem that exposure light is disturbed (such as scattering and absorption) during using the photomask, and therefore the particle of the undercut portion also needs removing. However, it is difficult to remove this foreign substance only with the conventional cleaning method in the related art, and in addition, there is a problem such that an overhung mask pattern may be destroyed, resulting in producing an inferior quality when the high-pressure water cleaning or the ultrasonic wave cleaning, which is the physical cleaning, is employed.

Under such a background as described thus far, it is an object of the present invention to provide a particle removing method and an apparatus used therefor, and particle removing solvent which can remove minute particles adhered to the fine pattern or the like without damaging the pattern or the like.

In order to solve the above-described problems, the present invention takes several aspects as follows.

In a first aspect, a method of cleaning an object is provided, wherein the object is cleaned by acting a desired force on the surface of the object to be cleaned in a state that liquid having 50 mPa.s or more of viscosity being contacted to at least the surface of the object to be cleaned.

In a second aspect, the cleaning method according to the first aspect is provided, wherein the desired force is a force generated in association with movement of the liquid.

In a third aspect, the cleaning method according to the first aspect is provided, wherein the desired force is a force generated by moving the object and a member different from the object relatively in a non-contact state.

In a fourth aspect, the cleaning method according to the first aspect is provided, wherein the desired force is an externally applied force.

In a fifth aspect, the cleaning method according to any one of the first to fourth aspects is provided, wherein the liquid has a predetermined pH value that can control a zeta potential of the object.

In a sixth aspect, the cleaning method according to the fifth aspect is provided, wherein the pH value of the liquid is at least 6.

In a seventh aspect, the cleaning method according to any one of the first to sixth aspects is provided, wherein the object is a substrate.

In an eight aspect, the cleaning method according to any one of the first to seventh aspects is provided, wherein the object has a patterned structure on the surface.

In a ninth aspect, the cleaning method according to any one of the first to eighth aspects is provided, wherein the object is a photomask.

In a tenth aspect, the cleaning method according to either of the eighth aspect or the ninth aspect is provided,
wherein the object has a pattern having an undercut shape on the surface thereof.

In an eleventh aspect, a particle removing method for removing an adherent particle from an object is provided,
wherein the particle is removed by acting a desired force on the surface of the object to be cleaned in the state that liquid having 50 mPa.s or more of viscosity being contacted to at least the surface of the object to be cleaned.

In a twelfth aspect, the particle removing method according to the eleventh aspect is provided, wherein the desired force is a force generated in association with movement of the liquid.

In a thirteenth aspect, the particle removing method according to the eleventh aspect is provided, wherein the desired force is a force generated by moving the object and a member different from the object relatively in a non-contact state.

In a fourteenth aspect, the particle removing method according to the eleventh aspect is provided, wherein the desired force is an externally applied force.

In a fifteenth aspect, the particle removing method for removing an adherent particle from the object is provided, comprising:

making a contact state between liquid and at least a portion of the object to which the particle is adhered; and
moving the liquid at the corresponding portion in the contact state,

wherein said liquid has high viscosity with which a force generated in association with the movement of the liquid becomes larger than an adhesion force of the particle to the substrate.

In a sixteenth aspect, a particle removing method for removing an adherent particle from an object is provided, comprising:

interposing liquid at least between a portion of the object to which the particle is adhered and a member different from the object; and
moving the object and the member relatively in a non-contact state,

wherein said liquid has high viscosity with which the force generated in association with the relative movement becomes larger than the adhesion force of the particle to the substrate is used.

In a seventeenth aspect, the particle removing method according to either of the fourteenth aspect or fifteenth aspect is provided, wherein the viscosity of the liquid is 50 mPa.s or higher.

In an eighteenth aspect, the particle removing method according to any one of the eleventh to seventeenth aspects is provided, wherein the liquid has a predetermined pH value that can control a zeta potential of the object.

In a nineteenth aspect, the particle removing method according to any one of the eleventh to eighteenth aspects is provided, wherein the object is a substrate.

In a twentieth aspect, the particle removing method according to any one of the eleventh to nineteenth aspects is provided, wherein the object has a patterned structure on the surface.

In a twenty-first aspect, the particle removing method according to any one of the eleventh to twentieth aspects is provided, wherein the object is a photomask.

In a twenty-second aspect, the particle removing method according to either of the twentieth aspect or the twenty-first aspect is provided, wherein the object has a pattern having an undercut shape on the surface thereof.

In a twenty-third aspect, a cleaning apparatus for cleaning an object is provided, comprising:

> means for producing a contact state between liquid of 50 mPa.s having higher viscosity and at least a surface of the object to be cleaned; and
> means for applying a desired force, with the liquid contacted with the surface of the object.

In a twenty-fourth aspect, the cleaning apparatus according to the twenty-third aspect is provided, wherein the means for applying the desired force, with the liquid contacted with the surface of the object, also serves as a means for moving the liquid.

In a twenty-fifth aspect, the cleaning apparatus according to the twenty-fourth aspect is provided, wherein the means for applying the desired force, with the liquid contacted with the surface of the object, also serves as a means for relatively moving the object and a member different from the object in a non-contact state.

In a twenty-sixth aspect, the cleaning apparatus according to the twenty-fifth aspect is provided, wherein the member different from the object has a planer area facing the object.

In a twenty-seventh aspect, the cleaning apparatus according to the twenty-sixth aspect is provided, wherein the planar area of the member different from the object has a rugged surface.

In a twenty-eighth aspect, the cleaning apparatus according to the twenty-third aspect is provided, wherein the means for applying the desired force, with the liquid contacted with the surface of the object also serves as a means for adding an external force.

In a twenty-ninth aspect, the cleaning apparatus according to any one of the twenty-third to twenty-eighth aspect is provided, further comprising a means for changing the viscosity of the liquid.

In a thirtieth aspect, the cleaning apparatus according to any one of the twenty-third to twenty-ninth aspect is provided, wherein the cleaning apparatus removes the particle adhered to the object.

In a thirty-first aspect, cleaning liquid to be used for cleaning an object is provided, wherein the liquid has a viscosity of 50 mPa.s or higher.

In a thirty-second aspect, the cleaning liquid according to the thirty-second aspect is provided, wherein the pH value of the liquid is pH6 or higher.

In the mechanisms described above, by applying the desired force in a contact state between the liquid having high-viscosity such as 50 mPa.s or higher and the object to be cleaned, the desired force can be adjusted to a force within a range which gives less damage to the object and provides a high cleaning capability. The desired force described in this specification includes a force generated by liquid itself and a force applied externally by a certain separate member.

The force generated by the liquid itself includes a viscosity resistance generated in association with movement of the liquid. The present invention designed to obtain a large force for cleaning the object not by using other physical force such as an ultrasonic wave or the pressure of sponge, but only by moving the liquid by utilizing a property of the viscosity which increases in association with the increase in the viscosity resistance. The means for moving the liquid includes a means for using a centrifugal force generated by the rotation of the object, a means for moving the liquid by moving the object, for example, by tilting the object to cause a gravitational force of the liquid, or a means for moving the liquid by an external force (a pressure or a pressing force). In addition, it is proved that a high viscosity liquid can be moved so as to be slid on the surface of the object by using low viscosity liquid having lower viscosity than the high viscosity liquid and causing the low viscosity liquid to act on the high viscosity liquid at a high flow rate (a flow rate at which the high viscosity liquid is moved by a pressure of the liquid or the like before the high viscosity liquid is mixed with the low viscosity liquid), and hence as the means for moving the liquid, a means for causing the low viscosity liquid to act at a high flow rate may be used. Although the type of the low viscosity liquid in this case is not specifically limited, a liquid which does not react to the high viscosity liquid and does not change the physical property thereof such as pH value is preferable since it is somewhat mixed with the high viscosity liquid. More specifically, a liquid of the same type as water or the high viscosity liquid but different only in viscosity is preferable. As the means for moving the liquid, the above-described means may be used independently or in combination of two or more of them.

In addition, the present invention is designed to obtain a large force for cleaning the object in a non-contact state, not using other physical forces such as an ultrasonic wave or the pressure of a sponge or the like, with the liquid interposed between an object and a member different from the object, but relatively moving both of them to cause a shearing stress to be generated, and utilizing the property of the shearing stress which becomes larger as the viscosity of the liquid is increased, thereby generating a larger shearing stress, with the high viscosity liquid interposed. The shearing stress in this specification is expressed by the following formula when liquid is interposed between the object and the member different from the object and when the member different from the object has a planer surface:

$$F = k \times S \times (dV / dh)$$

where F represents a shearing stress, k represents a coefficient of viscosity, S represents a surface area (surface area of the "planer surface"), V represents a relative speed between the surface of the object and the planer surface, h represents a distance between the surface of the object and the planer surface, and (dV / dH) represents a speed gradient between the object/planer surface and the vertical direction.

As is clear from the formula shown above, when the coefficient of viscosity k is large, the shearing stress increases as well, and the shearing stress can be adjusted by adjusting the speed gradient (dV/Dh) between the surface area S of the object and the object/planer surface, and the vertical direction.

According to the present invention, in the conventionally used ultrasonic wave cleaning, the scrub cleaning, and the high-pressure cleaning, the high viscosity-liquid is sometimes used. Since the high viscosity liquid generates a damping effect, damage to the object can be reduced more in comparison with the case in which a low viscosity liquid is brought into contact with the surface of the object to be cleaned.

In the present invention, the above-described methods can be used in combination.

In the present invention, the particle can be removed without giving any damage to the object by employing a liquid having a viscosity of 50 mPa.s or higher. In other words, the particle, which is adhered to the object relatively stubbornly or entered into and adhered to a minute recess on the surface of the object or the undercut portion and hence is not able to be removed with the conventional method since it may give a damage to the object, can now be removed easily from the object without affecting the object.

The viscosity of the liquid is preferably 700 mPa.s at maximum. When it exceeds 700 mPa.s, the liquid can hardly be fed by a force of a pump or the like, or hardly be rinsed, and hence practicability is lowered and, in addition, if the object is formed with a fine pattern, the possibility of destruction of the fine pattern is increased. In view of increase of the cleaning capability and reduction of the damage to the object, the viscosity of the liquid is more preferably in the range from 100 mPa.s to 400 mPa.s, and further preferably, from 200 mPa.s to 300 mPa.s.

The viscosity of the liquid is selected as needed according to the type of the particle to be removed and the condition of the surface of the object. For example, when the object has the rugged surface, or the finely patterned surface, an adequate viscosity is selected taking into account the size, arrangement and shape of the irregularity or the pattern, or the type, size and adhesion mechanism of the particle. For example, in the fine pattern, when the viscosity is too high, the surface tension increases correspondingly, and hence the liquid may not enter into a recessed portion of the pattern. In such a case, in order to allow the liquid to spread over the recessed portion of the pattern, the liquid may be diluted with a liquid having lower viscosity than the liquid, such as water, to adjust the viscosity.

The liquid preferably has a predetermined pH value that can control the zeta potential of the object.

The particle adhered to the surface of the object is normally adhered to the surface of the object in a charged state. In this case, when the zeta potential between the surface of the object and the particle adhered thereon is adjusted to a different positive or negative side (+ and -), an attracting force acts between the surface of the object and the particle. On the other hand, when the zeta potential between the surface of the object and the particle is the same positive or negative side (both are +, or both are -), they repulse against each other, and hence the particle can easily be removed from the surface of the object. Therefore, after the adherent particle is removed from the surface of the substrate, by controlling the pH value of the liquid so as to adjust the zeta potential between the surface of the object and the particle to the same positive or negative side, re-adhesion of the particle can be prevented. In the case where the object has a glass surface such as the photomask, since the zeta potential of the glass is pH 6 or higher and hence can easily be controlled to a minus value, the particle which is removed from the surface of the object can be prevented from re-adhering to the surface of the photomask, by setting the pH value of the liquid to pH6 or higher. The value of pH in the case of the object having the glass surface is more preferably 9 or higher.

In order to prevent adhesion of a new particle, the cleaning liquid is required not to contain particles larger than the particle which must be prevented from adhesion, and in the case of cleaning the photomask, the liquid after having subjected to filtration by a 0.1, $\mu$m filter is used.

While the liquid may be of any type, and is not specifically limited as long as the viscosity and the pH value meet the predetermined values, when considering safety for the human body, environmental anti-staining properties, and flame-retardant properties, water-based solution containing water soluble compounds such as polymeric glycol group including polyethylene glycol or polypropylene glycol, or ethylene oxide additives or propylene additives of polyatomic alcohol such as glycerin or nonionic surfactant may be preferably exemplified.

The nonionic surfactant includes polyoxyethylene alkyl ether ($R-O(CH_2CH_2O)nH$), polyoxyethylene alkyl phenyl ether, polyoxyethylene- polyoxypropylene blockpolymer, polyoxyethylene polyoxypropylene alkyl ether, polyoxyethylene glycerine fatty acid ester, polyoxyethylene sorbitan fatty acid ester, polyethylene glycol fatty acid ester, polyglyceryl fatty acid ester, and sorbitan fatty acid ester. Furthermore, a nonionic (anionic), amphoteric, and ionic (cationic) surfactants may also be used. The aforementioned water soluble compounds may be used independently, or two or more types may be combined.

In order to control the zeta potential, the aforementioned surfactants may include alkaline builders (auxiliary agents) such as sodium hydroxide, potassium hydroxide, sodium carbonate, potassium carbonate, sodium silicate, potassium silicate, sodium phosphate, and potassium phosphate. One of the alkaline builders given above may be used independently, or two or more of them may be used by combination. Preferably, an alkaline builder is selected in consideration of solubility into the object to be cleaned. For example, when a halftone-type phase-shift mask having a pattern formed of MoSi series material is cleaned, since the MoSi series material has low resistance to the alkaline solution, it is preferable to use sodium hydroxide and/or potassium hydroxide which is considered to give less damage to the pattern.

The cleaning apparatus of the present invention for cleaning the object, comprises a mechanism to make a contact state between the liquid having the viscosity of 50 mPa.s or more and at least the surface of the object to be cleaned; and a mechanism to add a desired force on the surface, with the surface of the object contacted with the liquid.

Here, as the aforementioned mechanism to make a contact state between the liquid having the viscosity of 50 mPa.s or more and the object to be cleaned, examples are given such as a mechanism to supply the liquid to the surface of the object by a nozzle and a mechanism to dip the object into a liquid layer containing the liquid.

The desired force includes a force generated by the liquid itself and a force externally applied from other members.

The force generated by liquid itself includes viscosity resistance generated in association with a movement of the liquid. Therefore, as the mechanism to add the desired force, that is, the mechanism to move the liquid on the surface of the object, examples are given such as a rotating mechanism of the object (liquid is moved by a centrifugal force), a tilting mechanism of the object (liquid is moved by a gravitational force), a mechanism to continuously supply the liquid by means of nozzle and shower or the like, a moving mechanism to swing the object in the liquid layer, a circulation mechanism of the liquid in the liquid layer, and a blowing mechanism using air and liquid.

In addition, it is proved that a high viscosity liquid can be moved so as to be slid on the surface of the object by using low viscosity liquid having lower viscosity than the high viscosity liquid and causing the low viscosity liquid to act on the high viscosity liquid at a high flow rate (high flow rate at which the high viscosity liquid is moved by a pressure or the like of the liquid before the high viscosity liquid is mixed with the low viscosity liquid). Therefore, as the mechanism to move the liquid, the mechanism to act the low viscosity liquid on the high viscosity liquid at a high flow rate may be used. Furthermore, one or two or more of the above-described mechanisms may be provided together.

Further, the present invention has a mechanism to interpose the liquid between the object and a member different from the object, and relatively move them. The member different from the object in this mechanism may be, for example, a sponge, a resin plate, a metal plate, and so on disposed so as to face the object in a non-contact state. Among the aforementioned members, preferably the member having elasticity such as sponge is used. This is because even when the object and the member different from the object unexpectedly make contacts with each other for some reason or other, an impact caused thereby is absorbed and a danger of causing damage to the object can be reduced. Further preferably, this member has a planar area facing the object, from the viewpoint of effectively using the shearing stress. In this case, by varying the surface area of the planer area, the shearing stress can be adjusted. In addition, when the planar area has the rugged surface, movement of the liquid can be performed efficiently. Moreover, by making it possible to arbitrarily change a moving speed and a directionality of the liquid, the shearing stress can be properly adjusted, in accordance with a spot on the surface of the object or the kind of the object. In addition, the shearing stress can be adjusted by adjusting the distance between the object and the member different from the object. Therefore, preferably the apparatus of the present invention has a mechanismt to control a distance between the object and the member different from the object. In the present invention, the term "non-contact" indicates that the distance therebetween is larger than zero. However, in order to avoid possibility of contact between the object and the member different from the object during relative movement thereof, the distance therebetween is preferably at least 0.1 mm. Furthermore, by having the means to arbitrarily change the viscosity of the liquid, the shearing stress can be properly adjusted, in accordance with the spot on the surface of the object and the kind of the object. As the means to arbitrarily change the viscosity of the liquid, examples are given such as a mechanism to supply the low viscosity liquid to the high viscosity liquid by mixing, and a mechanism to entirely or locally supply the low viscosity liquid to the high viscosity liquid already supplied. The mechanism to supply the low viscosity liquid also serves as the mechanism to supply the low viscosity liquid for moving the high viscosity liquid and the mechanism to change the flow rate.

Further, as the means to add an externally applied desired force on the surface of the object, an example is given such as a means to supply the high pressure liquid thereto in the high-pressure cleaning, such as the sponge or brush, which can be used in contact with the object in the ultrasonic wave or scrub cleaning. This means may be used by combining the means for bringing the aforementioned liquid into contact with the surface of the object and the means for moving the liquid on the surface of the object.

Although the present invention is applied to any object, it is applied to objects of an electronic device substrate and an optical device substrate, etc., where a minute adherent particle poses a problem in particular. Particularly, the present invention has effects in cleaning a fragile object and removing the particle, which may involve a problem of causing a damage to the object during the cleaning process in particular. More specifically, a lithography mask is given as an example, such as a photomask formed of a thin film and having a fine pattern formed thereon. Particularly, the present invention is effectively applied to the photomask having a fragile pattern such as a pattern having an undercut shape, as seen in a so-called Levenson type phase-shift mask having an undercut on the light-shielding pattern by trenching the substrate.

Brief Description of the Drawings

Fig. 1 is an explanatory view illustrating a particle removing method according to an example 1 of the present invention.
Fig. 2 is an explanatory view illustrating the particle removing method according to an example 2 of the present invention.
Fig. 3 is an explanatory view illustrating the particle removing method according to an example 3 of the present invention.
Fig. 4 is an explanatory view illustrating the particle removing method according to an example 4 of the present invention.
Fig. 5 is an explanatory view illustrating the particle removing method according to an example 5 of the present invention.
Fig. 6 is an explanatory view illustrating the particle removing method according to an example 6 of the present invention.
Fig. 7 is an explanatory view illustrating the particle removing method according to an example 7 of the present invention.
Fig. 8 is an explanatory view illustrating the particle removing method according to an example 8 of the present invention.
Fig. 9 is an explanatory view illustrating the particle removing method according to an example 9 of the present invention.
Fig. 10 is an explanatory view illustrating the particle removing method according to an example 10 of the present invention.

Reference Numerals

1    dip tank
2    high viscosity liquid
3    photomask

Best Mode for Carrying Out the Invention

Referring now to the examples, the present invention will be described further in detail. In the following examples, a particle removing method which is an embodiment of the present invention will be described as an example. However, these examples correspond to examples of a cleaning method of the present invention. Examples of an apparatus stated in the description correspond to examples of a particle removing apparatus and the cleaning apparatus according to the present invention.

Example 1

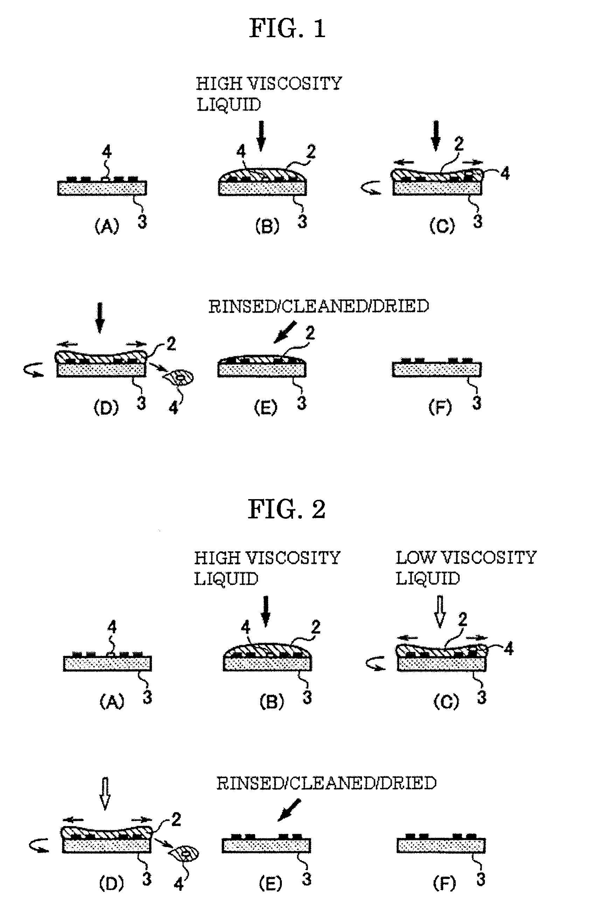

Fig. 1 is an explanatory view illustrating a particle removing method according to an example 1 of the present invention. Referring now to Fig. 1, the particle removing method according to the example 1 will be described. In the particle removing method according to the example 1, a photomask 3 to be cleaned is installed on an object holding part (not shown) which fixes and rotates the photomask 3 by a vacuum adsorption device or the like (Fig. 1A), and by a liquid supply part, a high viscosity liquid 2 is supplied to an upper surface of the photomask 3 to be cleaned using a dripping nozzle (not shown) (Fig. 1B).

Then, the photomask 3 is rotated while supplying the high viscosity liquid 2. By rotating the photomask 3 in this manner, the high viscosity liquid 2 moves by a centrifugal force (Fig. 1C). A rotating speed at this time was set to the speed capable of relatively moving the liquid efficiently with respect to the photomask (approx. 200 rpm). While the high viscosity liquid 2 is moved, a particle 4 is removed, while containing a particle 4 adhered to the photomask 3 in the high viscosity liquid 2. Then, the particle thus contained is prevented from re-adhering to the photomask 3, by controlling the zeta potential of the high viscosity liquid 2, and is removed from the photomask 3. (Fig. 1D).

The high viscosity liquid 2 may be supplied, with the photomask 3 rotated. By controlling the rotating speed, the high viscosity liquid 2 is supplied to the upper surface of the photomask 3, and the liquid 2 thus supplied is made to flow around from the periphery to a lower surface of the photomask 3, thereby cleaning a backside face. The photomask with the high viscosity liquid 2 attached thereto is rinsed by pure water or the like to remove the high viscosity liquid 2 therefrom before being dried (Fig. 1E). Then, the photomask 3 is cleaned, rinsed, and dried by using the conventional cleaning method (Fig. 1F).

The aforementioned high viscosity liquid 2 is prepared by adding purified water or pure water to polyoxyethylene alkyl ether (R-O $(CH_2CH_2O)nH$), i.e. a nonionic surfactant to obtain a viscosity of 250 mPa.s (viscosity at 20°C (substantially the same temperature as the time of usage), adding potassium hydroxide (KOH), i.e. an alkaline builder (auxiliary agent) to obtain pH10, and adjusting the liquid so as to have 250 mPa.s(20°C) of viscosity and 10 in pH value.

According to the particle removing method of the example 1, the photomask 3 is installed on a device which can perform rotating operation, then the high viscosity liquid 2 is supplied to the surface of the photomask 3 to be cleaned, and then the photomask 3 is rotated to move the high viscosity liquid 2. Therefore, while the high viscosity liquid 2 is moved, the particle 4 is removed, while containing the particle 4 adhered to the photomask 3 in the high viscosity liquid 2. Further, the particle 4 thus contained in the liquid 2 is prevented from re-adhering to the photomask by controlling the zeta potential of the high viscosity liquid 2, and is removed from the photomask 3.

According to this example, it becomes possible to remove the particle which can not be removed by the conventional cleaning (SPM cleaning and APM cleaning). In addition, it becomes possible to remove the particle, without causing damages which may occur during the conventional physical cleaning such as the scrub cleaning.

Example 2

Fig. 2 is an explanatory view illustrating the particle removing method according to an example 2 of the present invention. Referring now to Fig. 2, the particle removing method according to the example 2 will be described hereafter. In the particle removing method according to the example 2, the photomask 3 to be cleaned is installed on the object holding part (not shown) which fixes and rotates the photomask 3 by the vacuum adsorption device or the like (Fig. 2A), and then, the high viscosity liquid 2 which is the same liquid as that used in the example 1 is supplied to the cleaning surface of the photomask 3 through the liquid supply part such as the dripping nozzle or the like, not shown (Fig. 2B). In this case, vibrations of the ultrasonic wave may be applied to the object by an ultrasonic wave generating device, not shown. Subsequently, the high viscosity liquid 2 is moved by injecting a lower viscosity liquid than the high viscosity liquid such as pure rinsing water at a large flow rate, to the photomask surface to be cleaned, so that the high viscosity liquid is moved before mixing with the low viscosity liquid. (Fig. 2C).

The high viscosity liquid 2 is moved, while containing the particle 4 adhered to the photomask 3 in the high viscosity liquid 2. Then, the particle 4 thus contained in the liquid 2 is prevented from re-adhering to the photomask 3 by controlling the zeta potential of the high viscosity liquid 2, and is removed from the photomask 3. (Fig. 2D). In this case, a method of moving the high viscosity liquid 2 only by rotation, or a method of moving the high viscosity liquid 2 by dripping, with the photomask rotated, may be used. Further, pressure or ultrasonic wave may be applied to the low viscosity liquid such as the pure rinsing water.

Alternatively, a method of injecting the high viscosity liquid 2 to the upper surface of the photomask 3 by controlling the rotating speed, and making the high viscosity liquid 2 flow around from the periphery to the lower surface of the photomask 3, may be used. The photomask having the high viscosity liquid 2 attached thereto is rinsed with pure water or the like to remove the high viscosity liquid 2 therefrom before being dried (Fig. 2E). Then, the photomask 3 is cleaned, rinsed, and dried by using the conventional cleaning method (Fig. 2F).

According to the particle removing method of the example 2, the photomask 3 to be cleaned is installed on the device which can perform rotating operation, then the high viscosity liquid 2 is supplied to the surface of the photomask to be cleaned. Subsequently, the high viscosity liquid 2 is moved by injecting the lower viscosity liquid than the high viscosity liquid such as pure rinsing water, to the photomask surface to be cleaned at a large flow rate, so that the high viscosity liquid is moved before mixing with the low viscosity liquid. Then, the high viscosity liquid 2 is moved, while containing the particle 4 adhered to the photomask 3 in the high viscosity liquid 2. Further, the particle 4 thus contained in the high viscosity liquid 2 is prevented from re-adhering to the photomask 3 by controlling the zeta potential of the high viscosity liquid 2, and is removed from the photomask 3.

According to this example, it becomes possible to remove the particle which can not be removed by the conventional cleaning (SPM cleaning and APM cleaning). In addition, it becomes possible to remove the particle, without causing damages which may occur during the conventional physical cleaning such as the scrub cleaning.

This example can cope with various particles by using the low viscosity liquid. Specifically, even when there are a plurality of kinds, sizes, and adhesion mechanisms of the particle to be removed, the particle can be efficiently removed by selecting the high viscosity liquid in accordance with the aforementioned kinds, sizes, and mechanisms, and by combining the high viscosity liquid thus selected with the low viscosity liquid. In addition, when the low viscosity liquid serves as a pH control agent, it becomes possible to efficiently remove the particle and prevent a re-adhesion thereof, and also it becomes possible to remove the high viscosity liquid containing the particle, with the pH value controlled. In this example, the high viscosity liquid 2 is moved by injecting the low viscosity liquid to the photomask surface at a large flow rate, so that the high viscosity liquid is moved before the high viscosity liquid is mixed with the low viscosity liquid. However, the present invention is not limited thereto, and the high viscosity liquid may be moved by adjusting the viscosity by diluting the high viscosity liquid with the low viscosity liquid.

In this example, when providing ultrasonic wave vibrations to the object with the ultrasonic wave generating device, particle removing capability is improved, and hence the particle can easily be removed.

In addition, since the liquid having high viscosity serves as the damping material against the ultrasonic wave vibrations, damages to the photomask can be reduced in comparison with the ultrasonic wave vibrations through the low viscosity liquid in the related art.

(Example 3)

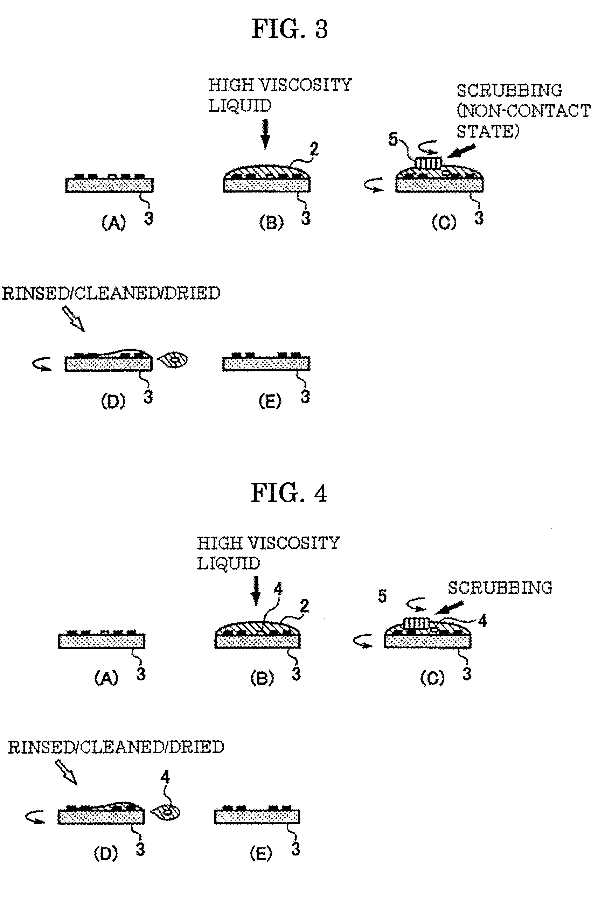

Fig. 3 is an explanatory view illustrating the particle removing method according to an example 3 of the present invention. Referring now to Fig. 3, the particle removing method in the example 3 will be described. In the particle removing method according to the example 3, the photomask 3 to be cleaned is installed on the object holding part (not shown) which can perform rotating operation (Fig. 3A), and the same high viscosity liquid 2 as that used in the example 1 and the example 2 is supplied to the surface of the photomask to be cleaned by the liquid supply part using the dripping nozzle (not shown) (Fig. 3B).

Subsequently, a gap (ex. approx. 1 mm) is provided between the photomask 3 and a sponge 5 (such as a circular sponge formed of PVA having diameter of 5 cm), and the sponge 5 is moved (ex. 100 mm/sec.) by an arm (not shown) for holding the sponge on the photomask 3 while keeping a non-contact state by keeping the aforementioned gap, whereby the entire surface of the photomask is scanned (Fig. 3C). At this time, the sponge itself is also rotated. By moving the high viscosity liquid 2, the particle 4 adhered to the phoromask 3 is moved, with the particle 4 contained in the high viscosity liquid 2 ((Fig. 3D). The gap between the photomask 3 and the sponge is controlled by the height from the position where the sponge dipped in the high viscosity liquid comes into contact with the photomask.

Furthermore, the particle 4 contained in the high viscosity liquid 2 is prevented from re-adhering to the photomask 3 by controlling the zeta potential of the high viscosity liquid 2 and is removed from the photomask 3. Since a non-contact state is made between the photomask 3 and the sponge 5, the particle 5 adhered to the sponge 5 or the like can also be prevented from re-adhering to the photomask 3. The photomask 3 with the high viscosity liquid 2 adhered thereto is rinsed by pure water or the like to remove the high viscosity liquid 2 therefrom before being dried. Then, the photomask 3 is cleaned, rinsed, and dried by using the conventional cleaning method (Fig. 3E).

According to this example, a relatively strong force can be acted on the particle adhered to the photomask 3, when the high viscosity liquid generated by rotating the photomask 3 is moved, and the photomask is scanned by the member such as a sponge different from the photomask (object) in a non-contact state.

As a result, according to this example, for example, in the example 1, it becomes possible to remove the particle having strong adhesion to the photomask, which has been hardly removed before. Further, it becomes possible to remove the particle, without causing damage that occurs in the conventional physical cleaning such as the scrub cleaning.

In the above-described example, cleaning capability can be adjusted at any part on the photomask by controlling the self rotation of the photomask and the sponge so as to make them rotate in the normal direction or in the reverse direction, or by controlling the rotating speeds thereof, and by controlling the scanning direction or the scanning speed of the sponge. In addition, by using a sponge having a rugged surface, it becomes possible to efficiently move the high viscosity liquid 2. Furthermore, the cleaning capability can be controlled by controlling the height of the photomask and the sponge and the surface area of the sponge, and also the cleaning capability can be controlled by properly combining the low viscosity liquid such as that used in the example 2.

(Example 4)

Fig. 4 is an explanatory view illustrating the particle removing method according to an example 4 of the present invention. Referring now to Fig. 4, the particle removing method according to the example 4 will be described. In the particle removing method according to the example 4, the photomask 3 to be cleaned is installed on the object holding part (not shown) which can perform rotating operation (Fig. 4A), and the same high viscosity liquid 2 as that used in the examples 1 to 3 is supplied to the surface of the photomask to be cleaned by the liquid supply part using the dripping nozzle (not shown) (Fig. 4B). Next, the photomask is scanned as kept in contact with the sponge 5 and so forth (so-called scrub cleaning) (Fig. 4C).

By moving the high viscosity liquid 2 by the rotation of the photomask and the sponge 5 (such as the circular sponge having diameter of 5cm formed of PVA), the particle 4 adhered to the phoromask 3 is moved, with the particle 4 contained in the high viscosity liquid 2. Further, the particle 4 contained in the liquid 2 is prevented from re-adhering to the photomask 3 by controlling the zeta potential of the high viscosity liquid 2, and is removed from the photomask 3. The photomask 3 with the high viscosity liquid 2 adhered thereto is rinsed by pure water or the like to remove the high viscosity liquid 2 therefrom (Fig. 4D) before being dried. Then, the photomask 3 is cleaned, rinsed, and dried by using the conventional cleaning method (Fig. 4E).

In the above-described embodiment, although the sponge 5 and the photomask 3 come into contact with each other, the high viscosity liquid 2 is interposed therebetween, and since the high viscosity liquid 2 serves as a damping agent and lubricant, risk of damages due to contact may be efficiently prevented.

(Example 5)

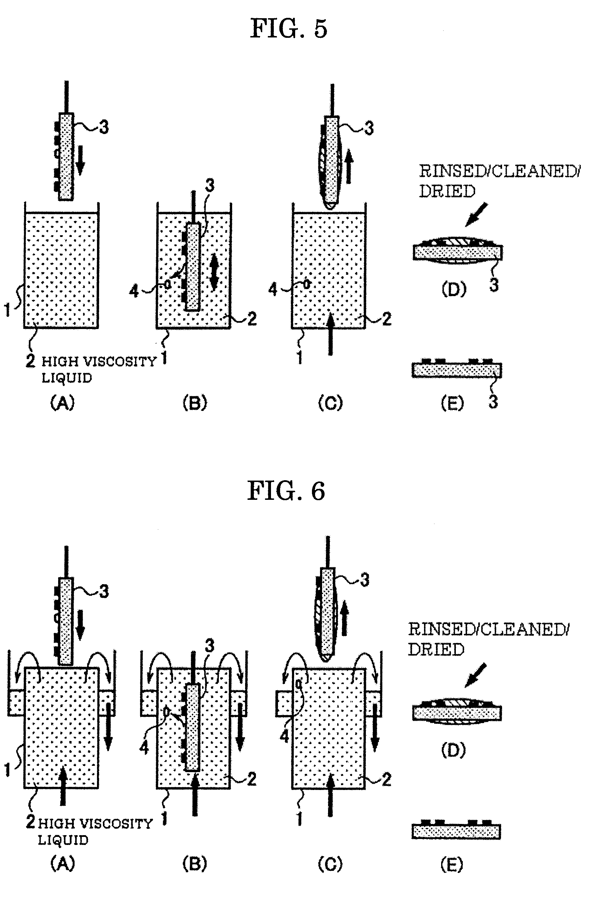

Fig. 5 is an explanatory view illustrating the particle removing method according to an example 5 of the present invention. Referring now to Fig. 5, the particle removing method according to the example 5 will be described. In the particle removing method according to the example 5, the same high viscosity liquid 2 as that used in the examples 1 to 4 is put in a dipping tank 1 (Fig. 5A). Subsequently, the photomask 3 to be cleaned is dipped in the liquid 2 (Fig. 5B).

Then, by picking up the photomask 3, the high viscosity liquid 2 is moved in the direction opposite to the lifting direction by its own weight, so that the particle 4 contained therein is removed from the photomask (Fig. 5C). The particle 4 thus removed is prevented from re-adhering to the photomask 3 by controlling the zeta potential of the high viscosity liquid 2, and is removed from the photomask while drifting freely in the high viscosity liquid.

In this case, by swinging the photomask in the high viscosity liquid 2 instead of picking up the photomask, the same effect can be obtained. Then, by rinsing the photomask by pure water or the like, the high viscosity liquid 2 is removed (Fig. 5D), and the photomask is cleaned, rinsed, and dried by using the conventional cleaning method before being dried (Fig. 5E).

According to the particle removing method of the example 5 described above, the photomask 3 is dipped into the high viscosity liquid. Then, by picking up or swinging the photomask, the particle 4 adhered to the photomask is removed and drifted in the high viscosity liquid 2. Further, by controlling the zeta potential, it becomes possible to prevent the particle from re-adhering to the photomask.

Thus, by cleaning this example, it became possible to clean the particle that could not be removed by the conventional cleaning (SPM cleaning and APM cleaning). In addition, it became possible to remove the particle, without causing damage that occurred in the conventional physical cleaning such as the scrub cleaning.

(Example 6)

Fig. 6 is an explanatory view illustrating the particle removing method according to an example 6 of the present invention. Referring now to Fig. 6, the particle removing method according to the example 6 will be described. In the particle removing method in the example 6, the same high viscosity liquid 2 as that used in the examples 1 to 5 is put in the dipping tank 1 (Fig. 6A). Subsequently, the photomask 3 to be cleaned is dipped in the high viscosity liquid 2, so that the particle to be removed is contained in the high viscosity liquid 2. Then, by circulating the high viscosity liquid 2 in the dipping tank 1, the vertical flow (flow rate) is provided (Fig. 6B).

The high viscosity liquid 2 allows the particle 4 thus contained therein to be removed from the photomask 3. The particle 4 thus removed is prevented from re-adhering to the photomask 3 by controlling the zeta potential of the high viscosity liquid 2, and is removed from the photomask 3 while drifting freely in the high viscosity liquid 2. (Fig. 6C)

In this condition, by circulating the high viscosity liquid 2 in the dipping tank 1, a liquid flow is provided from a lower portion to an upper portion of the dipping tank 1. However, the same effect can be obtained by adding the flow rate to the high viscosity liquid, irrespective of the direction such as stirring. The high viscosity liquid 2 is removed from the photomask by rinsing with pure water or the like before the photomask is dried. (Fig. 6D), and the photomask is cleaned, rinsed, and dried by using the conventional cleaning method (Fig. 6E).

Since the liquid 2 is made to flow, thereby making the movement of the liquid 2 large relatively to the photomask 3, further effective cleaning is realized.

(Example 7)

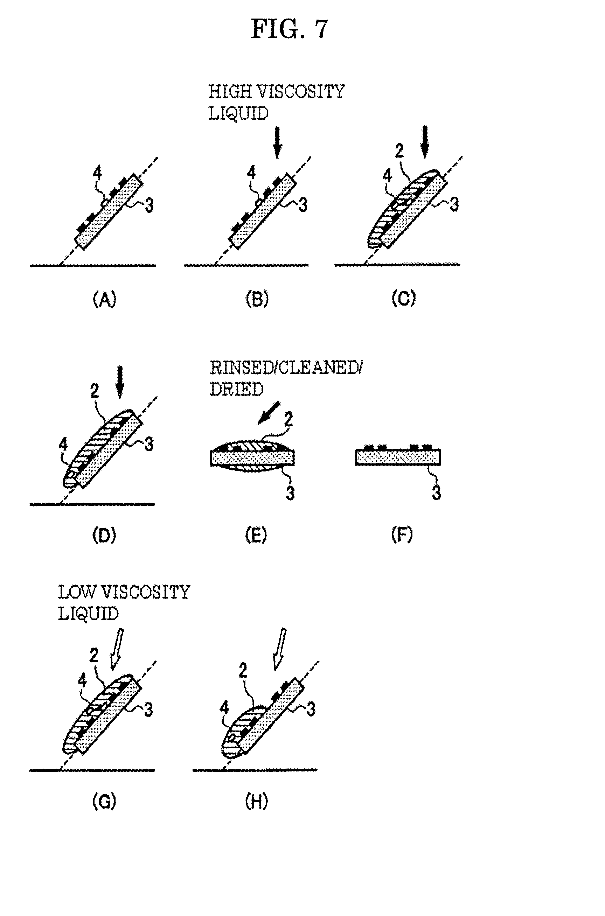

Fig. 7 is an explanatory view illustrating the particle removing method according to an example 7 of the present invention. Referring now to Fig. 7, the particle removing method according to the example 7 will be described. In the particle removing method according to the example 7, the photomask 3 is set in a tilted state (Fig. 7A), and the same high viscosity liquid 2 as that used in the embodiments 1 to 6 is dropped from the upper portion of the tilted photomask 3 (Fig. 7B) and the high viscosity liquid 2 is moved on the surface of the photomask 3 to be cleaned (Fig. 7C).

The particle 4 is removed from the photomask 3, while the high viscosity liquid 2 is moved, while containing the particle 4 adhered to the photomask 3 in the high viscosity liquid 2 (Fig. 7D). In addition, the particle 4 thus contained in the liquid 2 is prevented from re-adhering to the photomask 3 by controlling the zeta potential of the liquid 2, and is removed from the photomask 3 by moving to the lower portion of the tilted photomask.

In this example, by changing a tilting angle of the photomask 3, the moving speed of the high viscosity liquid can be controlled. Although the high viscosity liquid is moved only by the gravitational force in the above-described example, for example, the high viscosity liquid can also be moved by supplying (Fig. 7G) the low viscosity liquid such as pure water at the flow rate so that the high viscosity liquid is moved (Fig. 7H) before the high viscosity liquid is mixed with the low viscosity liquid.

The photomask 3 with the high viscosity liquid 2 adhered thereto is rinsed by pure water or the like to remove the high viscosity liquid 2 therefrom (Fig. 7E) before being dried. Then, the photomask 3 is cleaned, rinsed, and dried by using the conventional cleaning method (Fig. 7F).

According to the particle removing method of the example 7 described above, the photomask 3 is set in a tilted state, and the high viscosity liquid 2 is dropped from the upper portion of the tilted photomask 3, and the high viscosity liquid 2 is moved on the surface of the photomask 3 to be cleaned. The particle 4 is removed from the photomask 3 during movement of the high viscosity liquid 2, while containing the particle 4 adhered to the photomask 3 in the high viscosity liquid 2. Further, it becomes possible to prevent a re-adhesion of the particle 4 to the photomask 3 by controlling the zeta potential.

According to this example, the particle and the high viscosity liquid are moved by using the gravitational force and therefore moved by a simple apparatus. Accordingly, the particle removing method of this example is made adaptive to an increased size of the substrate. (Example 8)

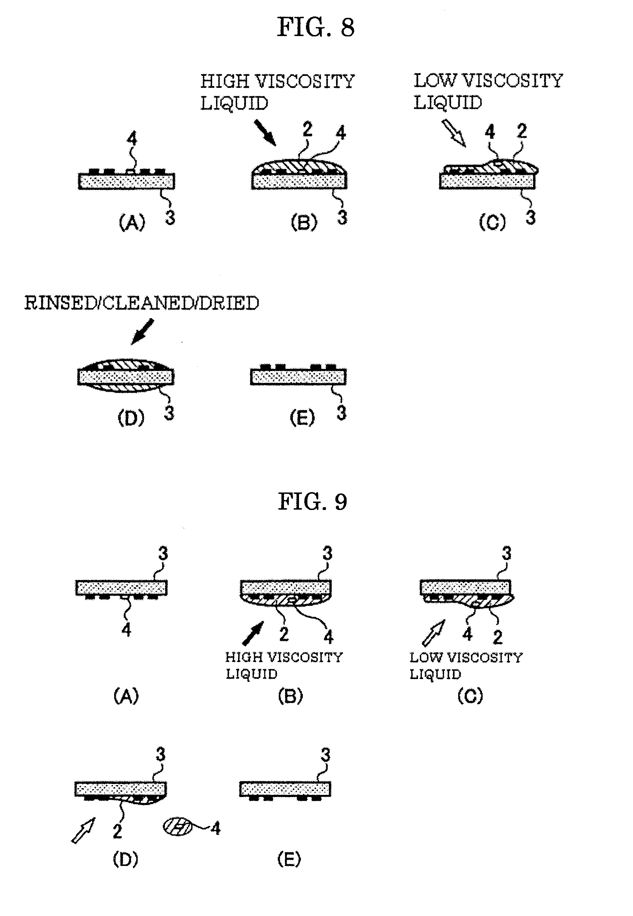

Fig. 8 is an explanatory view illustrating the particle removing method according to an example 8 of the present invention. Referring now to Fig. 8, the particle removing method according to the example 8 will be described. In the particle removing method according to the example 8, the surface of the photomask 3 to be cleaned is faced upward (Fig. 8A), and then the same high viscosity liquid 2 as that used in the examples 1 to 7 is supplied by using the dripping nozzle (not shown) (Fig. 8B).

Subsequently, the liquid having lower viscosity than the high viscosity liquid, such as pure rinsing water, is injected to the photomask surface to be cleaned at a high flow rate (Fig. 8C), so that the high viscosity liquid is moved on the surface of the photomask 3 to be cleaned, before the high viscosity liquid is mixed with the low viscosity liquid. While the high viscosity liquid 2 is moved, the particle 4 is removed, while containing the particle 4 adhered to the photomask 3 in the high viscosity liquid 2. Further, the particle 4 thus contained in the liquid 2 is prevented from re-adhering to the photomask 3 by controlling the zeta potential of the high viscosity liquid 2, and is removed from the photomask 3.

The force to move the liquid can be adjusted here by adjusting the pressure (flow rate) of the low viscosity liquid such as pure water. It is also possible to add the ultrasonic wave to the low viscosity liquid. Even in the case where the ultrasonic wave is added to the low viscosity liquid, the damage caused to the photomask is reduced through the high viscosity liquid, in comparison with the conventional ultrasonic wave cleaning. The photomask 3 with the high viscosity liquid 2 adhered thereto is rinsed by pure water or the like to remove the high viscosity liquid 2 therefrom before being dried (Fig. 8D). Then, the photomask 3 is cleaned, rinsed, and dried by using the conventional cleaning method (Fig. 8E).

According to the particle removing method of the example 8, the surface of the photomask 3 to be cleaned is faced upward, then the high viscosity liquid 2 is supplied. Next, the liquid having lower viscosity than the high viscosity liquid such as pure water is injected to the photomask surface to be cleaned, and the high viscosity liquid 2 is moved. Therefore, while the high viscosity liquid 2 is moved, the particle 4 is removed, while containing a particle 4 adhered to the photomask 3 in the high viscosity liquid 2. Then, the particle thus contained is prevented from re-adhering to the photomask 3, by controlling the zeta potential of the high viscosity liquid 2.

According to this example, by using the low viscosity liquid, the particle removing method of this example is made adaptive to various particles in the same way as the example 2.

(Example 9)

Fig. 9 is an explanatory view illustrating the particle removing method according to an example 9 of the present invention. Referring now to Fig. 9, the particle removing method according to the example 9 will be described. In the particle removing method according to the example 9, the surface of the photomask 3 to be cleaned is faced downward (Fig. 9A), and then the same high viscosity liquid 2 as that used in the examples 1 to 8 is injected (Fig. 9B). Then, the liquid having lower viscosity than the high viscosity liquid, such as pure rinsing water, is injected to the photomask surface to be cleaned at a high flow rate, so that the high viscosity liquid is moved on the surface of the photomask 3 to be cleaned, before the high viscosity liquid is mixed with the low viscosity liquid (Fig. 9C). The high viscosity liquid 2 is moved and removed from the photomask 3. Accordingly, the particle is removed in a state of being contained in the high viscosity liquid 2 (Fig. 9D).

Further, the particle 4 contained in the liquid 2 is prevented from re-adhering to the photomask 3 by controlling the zeta potential of the liquid 2 and removed from the photomask 3. The pressure or the ultrasonic wave may be added here to the low viscosity liquid such as pure water. Alternatively, the high viscosity liquid 2 may be injected to the upper surface of the photomask 3, or the high viscosity liquid 2 may be supplied to the upper surface of the photomask 3, and the liquid 2 thus supplied is made to flow around from the periphery to the lower surface of the photomask 3. The photomask with the high viscosity liquid 2 attached thereto is rinsed by pure water or the like to remove the high viscosity liquid 2 therefrom before being dried. Then, the photomask 3 is cleaned, rinsed, and dried by using the conventional cleaning method (Fig. 9E).

According to the particle removing method in the example 9, the surface of the photomask 3 to be cleaned is faced downward, then the high viscosity liquid 2 is injected, and the low viscosity liquid such as rinsing water is injected to the surface of the photomask 3 to be cleaned, and the high viscosity liquid 2 is moved. Accordingly, while the high viscosity liquid 2 is moved, the particle 4 is removed, while containing the particle 4 adhered to the photomask 3 in the high viscosity liquid 2. Further, the particle 4 thus contained is prevented from re-adhering to the photomask 3 by controlling the zeta potential of the high viscosity liquid 2, and is removed from the photomask.

According to this example, since the particle and the high viscosity liquid are removed by using the gravitational force, the particle removing method of this example can be realized with the simple apparatus.

(Example 10)

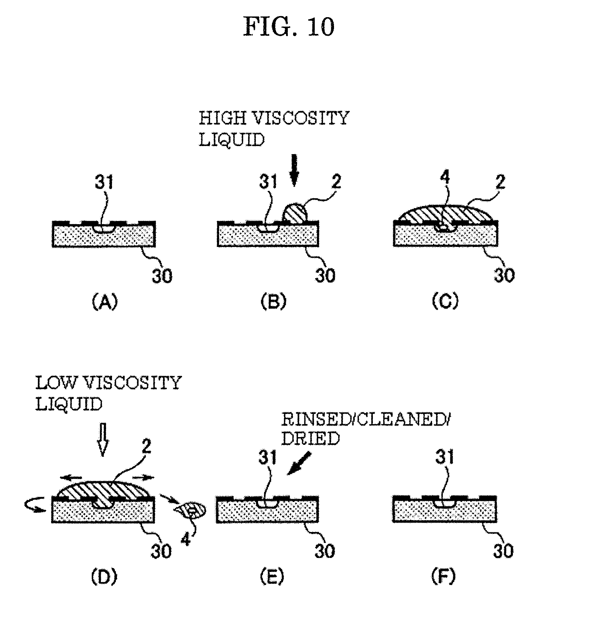

Fig. 10 is an explanatory view illustrating the particle removing method according to an example 10 of the present invention. Referring now to Fig. 10, the particle removing method according to the example 10 will be described. In the particle removing method of the example 10, by way of example, the method of the aforementioned example 2 is applied to a mask wherein a phase shift effect is obtained by a level difference which is generated by providing a recessed portion 31 formed on a glass substrate 30 by etching the glass substrate. The phase shift mask shown in Fig. 10 is referred to as the Levenson type phase shift mask, and the phase shift mask thus formed has a recessed portion formed on an opening portion of a line and space light shielding film patterns by alternately trenching the glass substrate. Then, by the recessed portion thus formed, a contrast of a transferred pattern is improved by using a phase difference of the exposure light generated in a trenched part and a non-trenched part. In this example, the recessed portion has an undercut shape trenched up to an inner side of the dimension of the light shielding film pattern. In the photomask of this type, the protruding portion of the light-shielding film has high risk of breakage by cleaning in the conventional cleaning method. In addition, when the particle is adhered to the undercut portion, it is difficult to remove the particle.

When the particle 4 is adhered to the recessed portion 31 of the glass substrate 30 (Fig. 10A), the glass substrate 30 is installed on the object holding part which can perform rotating operation, and thereafter the high viscosity liquid 2 is supplied to the surface of the glass substrate 30 by using the dripping nozzle (not shown) (Fig. 10B). When the liquid 2 enters into the recessed portion 31 of the glass substrate 30, the particle 4 is also taken into the liquid 2 accordingly (Fig. 10C).

Subsequently, with the glass substrate 30 kept rotating, the high viscosity liquid 2 is moved by injecting a lower viscosity liquid than the high viscosity liquid 2 such as pure rinsing water at a large flow rate, to the photomask surface to be cleaned, so that the high viscosity liquid is moved before mixing with the low viscosity liquid (Fig. 10D). By moving the liquid 2, the particle 4 adhered to the recessed portion 31 of the glass substrate 30 is also moved accordingly, with the particle contained in the liquid 2. Further, the particle 4 taken into the liquid 2 is prevented from re-adhering to the glass substrate 30 by controlling the zeta potential of the high viscosity liquid 2, and is removed from the glass substrate 30 (Fig. 10E).

The glass substrate 30 with the high viscosity liquid 2 attached thereto is rinsed by pure water or the like before being dried, and the high viscosity liquid 2 is thereby removed. The glass substrate 30 is cleaned, rinsed, and dried by using the conventional cleaning method (Fig. 10F). Here, either method may be taken, such as a method of moving the high viscosity liquid 2 by only rotation, or a method of moving the high viscosity liquid 2 by dripping the liquid, with the glass substrate 30 rotated. Furthermore, the physical cleaning such as the pressure or the ultrasonic wave can also be added to the low viscosity liquid such as pure rinsing water.

In addition, the method of injecting the high viscosity liquid 2 to the upper surface of the glass substrate 30 by controlling the rotating speed, and making the high viscosity liquid 2 flow around from the peripheral portion to the lower surface of the glass substrate 30, may also be used. Note that in this example, by way of example, explanation is given to a case where the example 2 is applied to the phase shift mask. However, there is no problem in applying the example 1 or examples 3 to 9 to the phase shift mask.

In this example, it becomes possible to remove the particle adhered to the undercut portion, without breakage of the protruding light shielding film portion by cleaning.

Since all the examples shown above were conducted at room temperature, the viscosity of the high viscosity liquid used here is about 250 mPa.s. Moreover, in the aforementioned examples, in order to adjust the viscosity of the high viscosity liquid, the high viscosity liquid is diluted with low viscosity water such as purified water or pure water. However, the viscosity can also be adjusted by changing the viscosity under temperature control of the liquid. In this case, the temperature control of the liquid may be performed in such a way that the temperature of the dipping tank is adjusted, the temperature of the liquid before dripping is controlled, and the temperature of the liquid is also controlled indirectly by previously controlling the temperature of the substrate. In other words, the viscosity of the liquid may be set to be a suitable viscosity in the temperature at which the particle is removed.

Furthermore, as a method of controlling the viscosity of the high viscosity liquid, the high viscosity liquid may be controlled to a required viscosity by mixing the high viscosity liquid and the lower viscosity liquid than the high viscosity liquid, before, immediately before, and simultaneously with making a contact state between the high viscosity liquid and the substrate. Further, as a mixing method of the high viscosity liquid and the low viscosity liquid such as pure water, for example there are methods such as mixing them in a buffer tank; injecting the high viscosity liquid and the low viscosity liquid from the nozzle respectively and mixing them before they are brought into contact with each other; or injecting the high viscosity liquid and the low viscosity liquid from the nozzle, supplying them to the surface of the substrate, and mixing them on the substrate.

In addition, it becomes possible to efficiently remove the particle, by properly selecting the viscosity and pH of the high viscosity liquid and a specific technique of removing the particle or the like, in accordance with the kind, size, and adhesion mechanism of the particle to be removed, as specifically explained in each example described above.

Further, in the aforementioned example, examples are given such that the present invention is applied to cleaning the photomask used in the manufacturing process of the semiconductor and liquid crystal or the like. However, the present invention is also applied to the cleaning of a semiconductor wafer, and particularly to a post-cleaning of CMP (Chemical Mechanical Polishing), which is a polishing process, and also applied to substrates for electronic devices such as liquid crystal substrate.

Industrial Applicability

To provide a particle removing method capable of removing a minute particle adhered to a fine pattern or the like, by bringing the liquid with 50 mPa.s or more viscosity into contact with the particle, and removing the liquid together with the particle from an object, without causing damage to patterns and so forth. Therefore, the present invention can be applied to cleaning of the photomask used in the process of manufacturing a semiconductor or a liquid crystal, to cleaning of a semiconductor wafer, and especially, to post cleaning of CMP (Chemical Mechanical Polishing), which is a polishing process, and to substrates for electronic devices such as liquid crystal substrate.

**Claims**

1. A cleaning method for cleaning an object, comprising:

   wherein the object is cleaned by acting a desired force on the surface of the object to be cleaned in a state that liquid having 50 mPa.s or more of viscosity being contacted to at least the surface of the object to be cleaned.

2. The cleaning method according to claim 1, wherein the desired force is a force generated in association with movement of the liquid.

3. The cleaning method according to claim 1, wherein the desired force is a force generated by moving the object and a member different from the object relatively in a non-contact state.

4. The cleaning method according to claim 1, wherein the desired force is an externally applied force.

5. The cleaning method according to any one of claims 1 to 4, wherein the liquid has a predetermined pH value that can control a zeta potential of the object.

6. The cleaning method according to claim 5, wherein the pH value of the liquid is at least 6.

7. The cleaning method according to any one of claims 1 to 6, wherein the object is a substrate.

8. The cleaning method according to any one of claims 1 to 7, wherein the object has a patterned structure on the surface.

9. The cleaning method according to any one of claims 1 to 8, wherein the object is a photomask.

10. The cleaning method according to either of claim 8 or claim 9, wherein the object has a pattern having an undercut shape on the surface thereof.

11. A particle removing method for removing an adherent particle from an object, wherein the particle is removed by acting a desired force on the surface of the object to be cleaned in the state that liquid having 50 mPa.s or more of viscosity being contacted to at least the surface of the object to be cleaned.

12. The particle removing method according to claim 11, wherein the desired force is a force generated in association with movement of the liquid.

13. The particle removing method according to claim 11, wherein the desired force is a force generated by moving the object and a member different from the object relatively in a non-contact state.

14. The particle removing method according to claim 11, wherein the desired force is an externally applied force.

15. The particle removing method for removing an adherent particle from the object, comprising:

   making a contact state between liquid and at least a portion of the object to which the particle is adhered; and
   moving the liquid at the corresponding portion in the contact state,

wherein said liquid has high viscosity with which a force generated in association with the movement of the liquid becomes larger than an adhesion force of the particle to the substrate.

16. A particle removing method for removing an adherent particle from an object, comprising:

interposing liquid at least between a portion of the object to which the particle is adhered and a member different from the object; and moving the object and the member relatively in a non-contact state,

wherein said liquid has high viscosity with which the force generated in association with the relative movement becomes larger than the adhesion force of the particle to the substrate.

17. The particle removing method according to either of claim 14 or claim 15, wherein the viscosity of the liquid is 50 mPa.s or higher.

18. The particle removing method according to any one of claim 11 to claim 17, wherein the liquid has a predetermined pH value that can control the zeta potential of the object.

19. The particle removing method according to any one of claim 11 to claim 18, wherein the object is a substrate.

20. The particle removing method according to any one of claim 11 to claim 19, wherein the object has a patterned structure on the surface.

21. The particle removing method according to any one of claim 11 to claim 20, wherein the object is a photomask.

22. The particle removing method according to either of claim 20 or claim 21, wherein the object has a pattern having an undercut shape on the surface thereof.

23. A cleaning apparatus for cleaning an object, comprising:

means for producing a contact state between liquid of 50 mPa.s having higher viscosity and at least a surface of the object to be cleaned; and means for applying a desired force, with the liquid contacted with the surface of the object.

24. The cleaning apparatus according to claim 23, wherein the means for applying the desired force, with the liquid contacted with the surface of the object, also serves as a means for moving the liquid.

25. The cleaning apparatus according to claim 24, wherein the means for applying the desired force, with the liquid contacted with the surface of the object, also serves as a means for relatively moving the object and a member different from the object in a non-contact state.

26. The cleaning apparatus according to claim 25, wherein the member different from the object has a planer area facing the object.

27. The cleaning apparatus according to claim 26, wherein the planar area of the member different from the object has a rugged surface.

28. The cleaning apparatus according to claim 23, wherein the means for applying the desired force, with the liquid contacted with the surface of the object also serves as a means for adding an external force.

29. The cleaning apparatus according to any one of claim 23 to claim 28, further comprising a means for changing the viscosity of the liquid.

30. The cleaning apparatus according to any one of claim 23 to claim 29, wherein the cleaning apparatus removes the particle adhered to the object.

31. Cleaning liquid to be used for cleaning an object, wherein the solvent has a viscosity of 50 mPa.s or higher.

32. The cleaning liquid according to claim 31, wherein the pH value of the liquid is pH6 or higher.

# FIG. 1

HIGH VISCOSITY
LIQUID

(A) 4 3

(B) 4 2 3

(C) 2 4 3

(D) 2 3 4

RINSED/CLEANED/DRIED

(E) 2 3

(F) 3

# FIG. 2

HIGH VISCOSITY
LIQUID

LOW VISCOSITY
LIQUID

(A) 4 3

(B) 4 2 3

(C) 2 4 3

(D) 2 3 4

RINSED/CLEANED/DRIED

(E) 3

(F) 3

# FIG. 3

HIGH VISCOSITY
LIQUID

SCRUBBING
(NON-CONTACT
STATE)

(A) 3

(B) 3

(C) 3

RINSED/CLEANED/DRIED

(D) 3

(E) 3

# FIG. 4

HIGH VISCOSITY
LIQUID

SCRUBBING

(A) 3

(B) 3

(C) 3

RINSED/CLEANED/DRIED

(D) 3

(E) 3

# FIG. 5

RINSED/CLEANED/
DRIED

HIGH VISCOSITY
LIQUID

(A)        (B)        (C)        (D)        (E)

# FIG. 6

RINSED/CLEANED/
DRIED

HIGH VISCOSITY
LIQUID

(A)        (B)        (C)        (D)        (E)

# FIG. 7

HIGH VISCOSITY
LIQUID

(A)          (B)          (C)

RINSED/CLEANED/
DRIED

(D)          (E)          (F)

LOW VISCOSITY
LIQUID

(G)          (H)

## FIG. 8

HIGH VISCOSITY LIQUID

LOW VISCOSITY LIQUID

(A)  (B)  (C)

RINSED/CLEANED/DRIED

(D)  (E)

## FIG. 9

(A)  (B)  (C)

HIGH VISCOSITY LIQUID

LOW VISCOSITY LIQUID

(D)  (E)

# FIG. 10

HIGH VISCOSITY
LIQUID

31

31    2

4    2

30

30

30

(A)

(B)

(C)

LOW VISCOSITY
LIQUID

RINSED/CLEANED/
DRIED

2

31

31

30    4

30

30

(D)

(E)

(F)

### INTERNATIONAL SEARCH REPORT

| | International application No. |
|---|---|
| | PCT/JP2004/004634 |

**A. CLASSIFICATION OF SUBJECT MATTER**
Int.Cl⁷ H01L21/304, B08B3/04, B08B7/00, G03F1/08

According to International Patent Classification (IPC) or to both national classification and IPC

**B. FIELDS SEARCHED**

Minimum documentation searched (classification system followed by classification symbols)
Int.Cl⁷ H01L21/304, B08B3/04, B08B7/00, G03F1/08

Documentation searched other than minimum documentation to the extent that such documents are included in the fields searched
Jitsuyo Shinan Koho           1940–1996   Toroku Jitsuyo Shinan Koho   1994–2004
Kokai Jitsuyo Shinan Koho    1971–1996   Jitsuyo Shinan Toroku Koho   1996–2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2001-334217 A (Sprout Co., Ltd.), 04 December, 2001 (04.12.01), | 1-6,11-18, 23-32 |
| Y | Page 9, left column, line 25 to right column, line 1; Fig. 8 & US 2001/0037818 A1 08 November, 2001 (08.11.01), Page 7, left column, lines 16 to 46; Fig. 8 | 7-10,19-22 |
| Y | JP 2-99175 A (Hitachi Electronics Engineering Co., Ltd.), 11 April, 1990 (11.04.90), Page 1, lower right column, line 10 to page 2, upper right column, line 6 (Family: none) | 7-10,19-22 |

☐ Further documents are listed in the continuation of Box C.      ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 06 July, 2004 (06.07.04) | 03 August, 2004 (03.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)